# EUROPEAN PATENT SPECIFICATION

(11) **EP 2 525 100 B1**
(45) Date of publication and mention of the grant of the patent: **16.12.2015**
(21) Application number: 11008429.0
(22) Date of filing: 20.10.2011
(51) Int. Cl.: F04D 17/04, F04D 25/06, F04D 29/30, G06F 1/20

(54) **Advection-type fan**
Advektionsgebläse
Ventilateur de type advection

(30) Priority: 19.05.2011 TW 100117547
(43) Date of publication of application: 21.11.2012
(73) Proprietor: Sunonwealth Electric Machine Industry Co., Ltd., Kaohsiung, Taiwan R.O.C. (TW)
(72) Inventor: Horng, Alex, Kaohsiung, Taiwan R.O.C. (TW)
(74) Representative: Köhler, Walter

(56) References cited:
- DE-A1- 1 428 174
- JP-A- 2003 307 198
- JP-A- 2009 185 727
- JP-A- 2010 007 609

## Description

### BACKGROUND OF THE INVENTION

### 1. Field of the Invention

The present invention generally relates to an advection-type fan and, more particularly, to an advection-type fan that draws and expels air in a radial direction.

### 2. Description of the Related Art

Conventional cooling fans are mainly categorized into two types: axial-flow type and blower type. The axial-flow type cooling fan has an axial air inlet and an axial air outlet opposite to the axial air inlet. The air can be drawn via the axial air inlet and then expelled via the axial air outlet. The blower type cooling fan has an axial air inlet in the axial direction and a radial air outlet in the radial direction thereof. Thus, the air can be drawn via the axial air inlet and then expelled via the radial air outlet for cooling operation.

However, the axial-flow type cooling fan must be mounted on a top of an electronic device to be cooled, such as on the top of a Central Processing Unit (CPU) of a computer. This is because the axial-flow type cooling fan can only expel air in the axial direction rather than the radial direction. Therefore, the axial height of the electronic device cannot be reduced. In addition, since the blower type cooling fan draws air via the axial air inlet (in the axial direction) and expels air via the radial air outlet (in the radial direction), the blower type cooling fan cannot be applied to electronic devices that draw air from a lateral face (from the radial direction), such as a handset or a Personal Digital Assistant (PDA).

In light of the problems, a conventional advection-type fan capable of drawing and expelling air in the radial direction was proposed. Referring to Fig. 1, a conventional advection-type fan 9 is disclosed by a Taiwanese Patent No. 553323 entitled "Fan Structure Having Horizontal Convection". The conventional advection-type fan 9 includes a housing 91 and an impeller 92. The housing 91 has at least one air inlet 911 and at least one air outlet 912, with a horizontal air channel 913 formed between the at least one air inlet 911 and the at least one air outlet 912. The impeller 92 is disposed in the horizontal air channel 913 and includes a hub 921 having a plurality of vanes 922 on an outer circumferential face thereof. In such an arrangement, the impeller 92 may rotate to create an air pressure difference between the at least one air inlet 911 and the at least one air outlet 912. Thus, airflows can be created between the at least one air inlet 911 and the at least one air outlet 912.

In the above structure, due to the facts that the vanes 922 are formed on the outer circumferential face of the hub 921, as well as that each vane 922 has its top edge aligned with a top face of the hub 921, the hub 921 will hinder the air from smoothly passing through the horizontal air channel 913. As a result, turbulence is caused and the cooling efficiency of the conventional advection-type fan 9 is therefore reduced.

JP 2003 307 198 A discloses a cross-flow fan with a hub comprising a step portion which faces a cover portion of the fan frame.

Another cross-flow fan is known from DE 1 428 174 A, an impeller of which is hub-less.

JP 2010-7609 A discloses a cross-flow fan with a hub comprising an arcuate face.

JP 2009-185 727 A shows an impeller for a cross-flow fan comprising a hub without a step portion.

### SUMMARY OF THE INVENTION

It is therefore the primary objective of this invention to provide an advection-type fan in which the air passing from an air inlet to an air outlet in a radial direction is not blocked by a hub thereof.

The invention discloses an advection-type fan comprising a fan frame, a driving module and an impeller. The fan frame has a first cover portion, a second cover portion and a lateral wall portion arranged between the first and second cover portions, wherein the lateral wall portion has an air inlet and an air outlet. The driving module is received in the fan frame and coupled with the first cover portion. The impeller has a hub and a plurality of vanes. The hub is rotatably coupled with the driving module and the vanes are coupled with the hub. The hub has an air-guiding protrusion facing the second cover portion. Each of the vanes has a top edge facing the second cover portion. The top edge of each of the vanes is higher than the air-guiding protrusion of the hub in an axial direction of the hub.

Furthermore, the invention discloses an advection-type fan comprising a fan frame, a driving module and an impeller. The fan frame has a first cover portion, a second cover portion and a lateral wall portion arranged between the first and second cover portions, wherein the lateral wall portion has an air inlet and an air outlet. The driving module is received in the fan frame and coupled with the first cover portion. The impeller has a hub and a plurality of vanes. The hub is rotatably coupled with the driving module and the vanes are coupled with the hub. The hub has an air-guiding protrusion facing the second cover portion. The air-guiding protrusion has at least one top point that is most adjacent to the second cover portion. Each of the vanes has a top edge facing the second cover portion. The top edge of each of the vanes is higher than the at least one top point of the hub in an axial direction of the hub.

Furthermore, the invention discloses an advection-type fan comprising a fan frame, a driving module and an impeller. The fan frame has a first cover portion, a second cover portion and a lateral wall portion arranged between the first and second cover portions, wherein the lateral wall portion has an air inlet and an air outlet. The driving module is received in the fan frame and coupled with the first cover portion. The impeller has a hub and a plurality of vanes. The hub is rotatably coupled with the driving module and the vanes are coupled with the hub. The hub has a step portion facing the second cover portion. The step portion has a plurality of top faces with different height in an axial direction of the hub. Each of the vanes has a top edge facing the second cover portion. The top edge of each of the vanes is higher than one of the top faces that is closest to the second cover portion in the axial direction of the hub.

### BRIEF DESCRIPTION OF THE DRAWINGS

The present invention will become more fully understood from the detailed description given hereinafter and the accompanying drawings which are given by way of illustration only, and thus are not limitative of the present invention, and wherein:
Fig. 1 shows an electronic device equipped with a conventional advection-type fan.
Fig. 2 is an exploded view of an advection-type fan according to a first embodiment of the invention.
Fig. 3 is a top view of the advection-type fan of the first embodiment of the invention.
Fig. 4 is a cross-sectional view of the advection-type fan of the first embodiment of the invention.
Fig. 5 is a cross-sectional view of the advection-type fan of the first embodiment having an air-guiding protrusion.
Fig. 6 is an exploded view of an advection-type fan according to a second embodiment of the invention.
Fig. 7 is a top view of the advection-type fan of the second embodiment of the invention.
Fig. 8 is a cross-sectional view of the advection-type fan of the second embodiment of the invention.
Fig. 9 shows is an exploded view of an advection-type fan according to a third embodiment of the invention.
Fig. 10 is a cross-sectional view of the advection-type fan of the third embodiment of the invention.

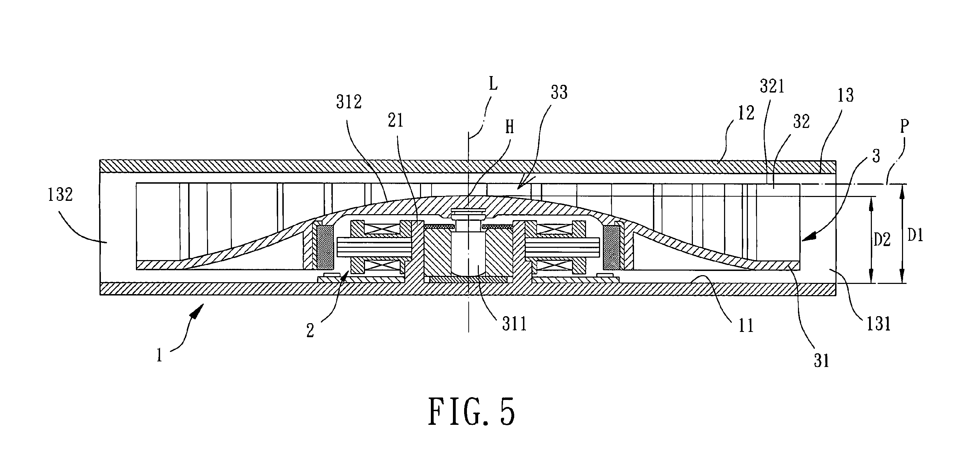

The invention as claimed pertains only to the geometry of the first embodiment and fig. 5. Therefore, hereafter the words "embodiment" and "embodiment of the invention" have to be simply construed as "example" as soon as they pertain to other geometries than the one of fig. 5.

In the various figures of the drawings, the same numerals designate the same or similar parts. Furthermore, when the term "first", "second", "third", "fourth", "inner", "outer" "top", "bottom" and similar terms are used hereinafter, it should be understood that these terms refer only to the structure shown in the drawings as it would appear to a person viewing the drawings, and are utilized only to facilitate describing the invention.

### DETAILED DESCRIPTION OF THE INVENTION

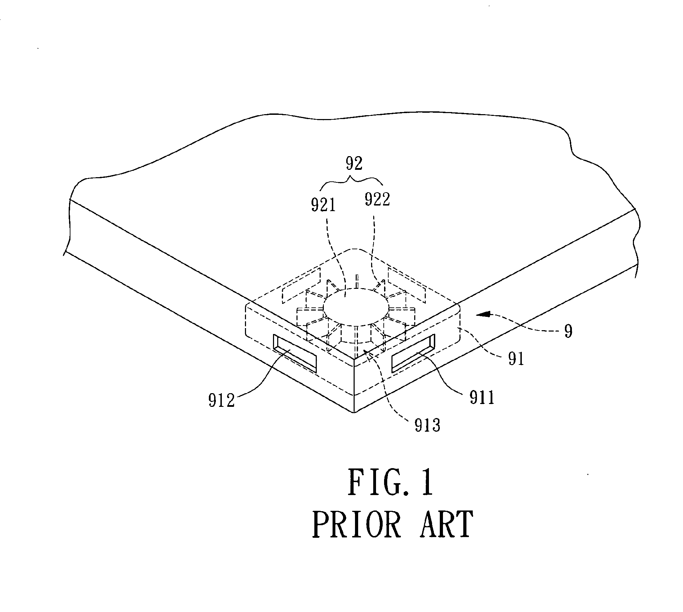

It is firstly clarified that the term "hub" referred hereinafter in the entire specification represents all portions of an impeller other than vanes of the impeller, and is somewhat different from the hub 921 (shown in Fig. 1) and those hubs of conventional axial-flow type and blower type impellers. In particular, the term "hub" mentioned in the invention includes a receiving portion for receiving a driving module, as well as a connection portion for connecting the receiving portion to the vanes, in which the connection portion may be implemented as a plate or similar structures with the same function, as disclosed in the drawings of various embodiments of the invention.

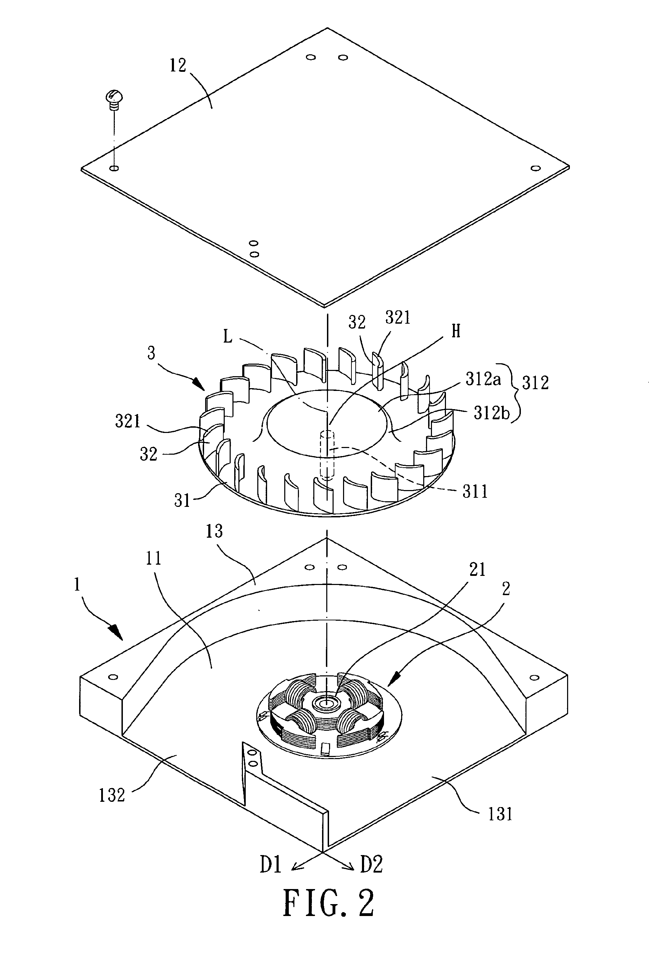

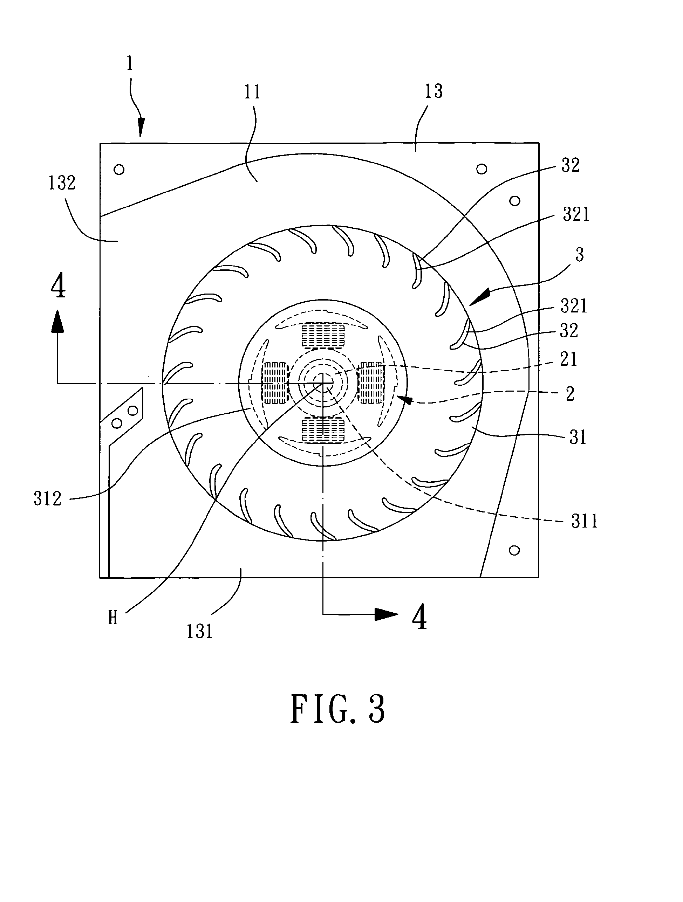

Referring to Figs. 2 to 4, an advection-type fan including a fan frame 1, a driving module 2 and an impeller 3 is disclosed according to a first embodiment of the invention. The fan frame 1 can be a hollow frame that allows air to flow therethrough in a radial direction. The driving module 2 is received in the fan frame 1. The impeller 3 can be rotatably coupled with the driving module 2 such that the driving module 2 can drive the impeller 3 to rotate.

The hollow frame of the fan frame 1 can be of various shapes such as a triangular shape, round shape or oval shape. In this embodiment, the fan frame 1 is in a rectangular shape. The fan frame 1 comprises a first cover portion 11 and a second cover portion 12 spaced from the first cover portion 11 by a distance. The fan frame 1 further comprises a lateral wall portion 13 between the first cover portion 11 and the second cover portion 12. The lateral wall portion 13 has an air inlet 131 and an air outlet 132. The quantity and location of the air inlet 131 and the air outlet 132 may be changed based on different requirements. The first cover portion 11, second cover portion 12 and lateral wall portion 13 may be integrally formed. In this embodiment, the first cover portion 11 is integrally formed with the lateral wall portion 13, and the second cover portion 12 is implemented as a cover plate that can be assembled to and disassembled from the lateral wall portion 13. Thus, the driving module 2 and the impeller 3 can be disposed in the fan frame 1. Furthermore, the air inlet 131 faces a first direction D 1 and the air outlet 132 faces a second direction D2 perpendicular to the first direction D1. This indicates that an angle difference of 90 degrees is presented between the air inlet 131 and the air outlet 132. However, the angle difference may be smaller than 90 degrees.

The driving module 2 can be any structure capable of driving the impeller 3 to rotate. In this embodiment, the driving module 2 can comprise a coil unit, a circuit board, a plurality of silicon steel plates and a shaft seat and so on. One skilled in the art may readily appreciate that the driving module 2 drives the impeller 3 to rotate under alternating magnetic fields (by cooperating with a permanent magnet of the impeller 3), so it is not described herein again for brevity.

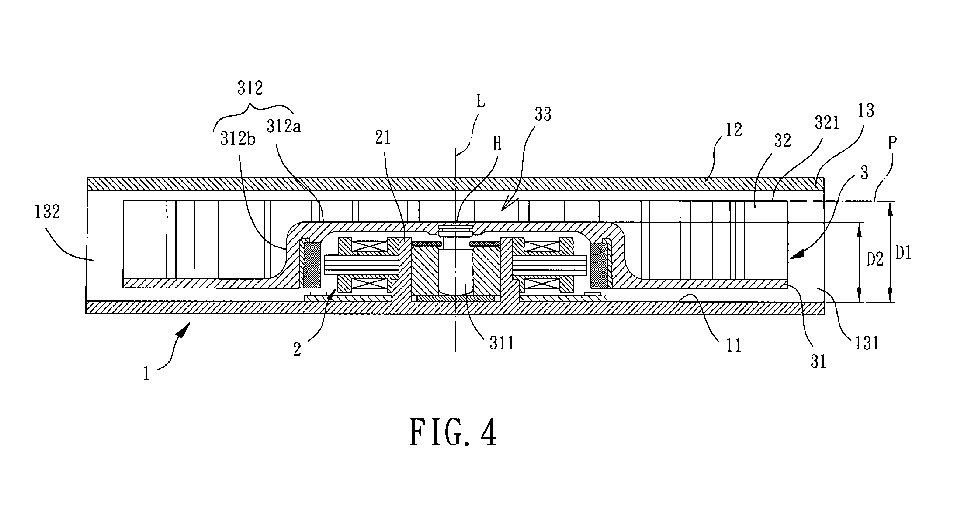

The impeller 3 has a hub 31 and a plurality of vanes 32. The hub 31 can be rotatably coupled with the driving module 2. In this embodiment, the hub 31 has a shaft 311 rotatably coupled with a shaft seat 21 of the driving module 2, thus coupling the hub 31 with the driving module 2. The vanes 32 are coupled with the hub 31. Referring to Fig. 4, the hub 31 has an air-guiding protrusion 312 facing the second cover portion 12, with the air-guiding protrusion 312 having at least one top point H that is most adjacent to the second cover portion 12 (compared to other portions of the hub 31). In addition, each vane 32 has a top edge 321 facing the second cover portion 12. The top edge 321 of the vane 32 is higher than the at least one top point H of the hub 31 in an axial direction L of the hub 31.

Specifically, the top edges 321 of the vane 32 can jointly define a horizontal reference plane P, and an air-guiding room 33 may be formed between the horizontal reference plane P and the air-guiding protrusion 312 of the hub 31. In such an arrangement, the hub 31 does not occupy any space of the air-guiding room 33, allowing the impeller 3 to drive the air to pass through the air-guiding room 33 more smoothly. Moreover, the top edge 321 of the vane 32 is spaced from the first cover portion 11 by a first distance D1, and the at least one top point H of the hub 31 is spaced from the first cover portion 11 by a second distance D2. The first distance D1 is designed in a larger value than the second distance D2 so that the air-guiding room 33 will have more space for air to pass therethrough.

Referring to Fig. 4, the air-guiding protrusion 312 of the hub 31 may consist of a plane face 312a and a lateral circumferential face 312b. The at least one top point H is located on the plane face 312a. The lateral circumferential face 312b connects the plane face 312a to other portion of the hub 31 other than the air-guiding protrusion 312. Alternatively, Referring to Fig. 5, the air-guiding protrusion 312 of the hub 31 can also be implemented as a cambered face having a center at which the top point H is located. The cambered face of the air-guiding protrusion 312 may allow the air to pass through the hub 31 more smoothly.

When the advection-type fan of the invention is in operation, the alternating magnetic fields generated by the driving module 2 may drive the impeller 3 to rotate. Based on this, when the advection-type fan is installed in an electronic device, the vanes 32 of the impeller 3 may draw external air into the fan frame 1 via the air inlet 131 and expel air via the air outlet 132, thereby dissipating the heat of the electronic device.

In summary, the advection-type fan of the first embodiment of the invention is characterized in the ability to draw air via the air inlet 131 and to expel the air via the air outlet 132 in the radial direction. Therefore, as opposed to the conventional mechanism where an axial-flow type fan is placed above a heat source (where heat is constantly emitted) in the electronic device, the invention may instead place the advection-type fan in a lateral side of the heat source to reduce the axial space occupied. This reduces the axial height of the electronic device. In addition, the advection-type fan can provide a better auxiliary cooling effect for those heat sources adjacent to the air outlet 132. More importantly, since the top edge 321 of the vane 32 is higher than the air-guiding protrusion 312 of the hub 31, the air-guiding room 33 may be formed between the top edge 321 of the vane 32 and the air-guiding protrusion 312 of the hub 31. Thus, the drawn air of the air inlet 131 can be guided to the air outlet 132 through the air-guiding room 33, which efficiently reduces the amount of air blocked by the hub 31. Thus, turbulence is prevented and overall cooling efficiency is improved.

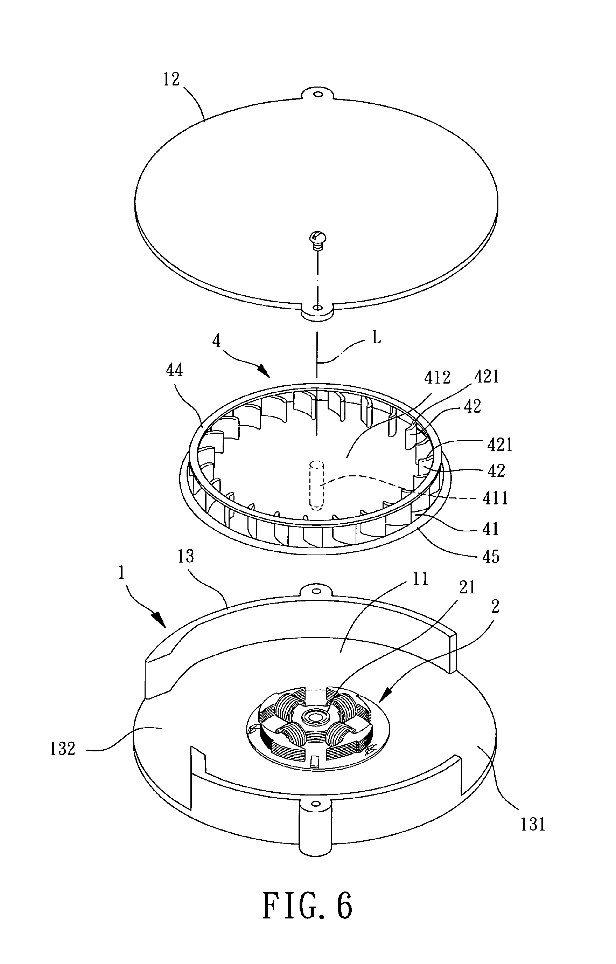

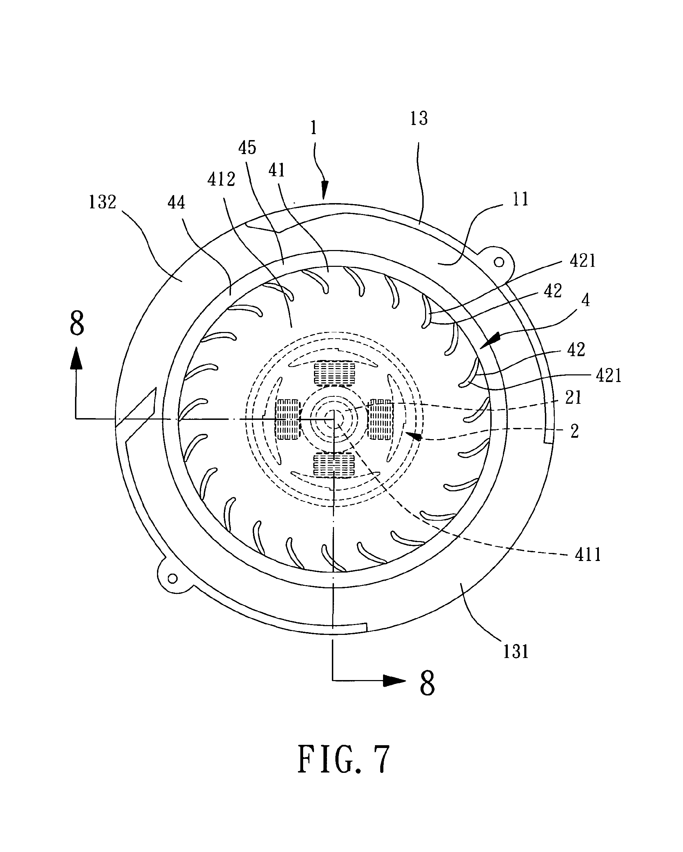

Referring to Figs. 6 to 8, an advection-type fan including a fan frame 1, a driving module 2 and an impeller 4 is disclosed according to a second embodiment of the invention. The fan frame 1 and the driving module 2 have been previously described. In this embodiment, the fan frame 1 is in a round shape, and the air inlet 131 is opposing to the air outlet 132. Namely, there is an angle difference of 180 degrees between the air inlet 131 and the air outlet 132. However, the angle difference may also be 90 to 180 degrees.

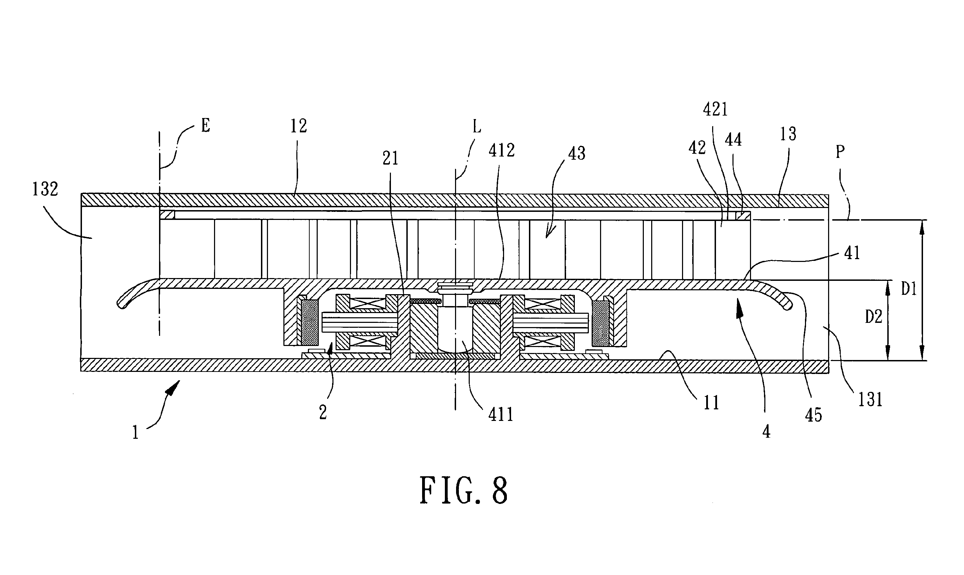

The impeller 4 comprises a hub 41 and a plurality of vanes 42, wherein the hub 41 may be rotatably coupled with the driving module 2. In this embodiment, the hub 41 has a shaft 411 rotatably coupled with the shaft seat 21 of the driving module 2, thus coupling the hub 41 with the driving module 2. The vanes 42 are coupled with the hub 41. Referring to Fig. 8, the hub 41 has an air-guiding plane 412 facing the second cover portion 12. In addition, each vane 42 has a top edge 421 facing the second cover portion 12. The top edge 421 of the vane 42 is higher than the air-guiding plane 412 of the hub 41 in an axial direction L of the hub 41.

Specifically, the top edges 421 of the vane 42 can jointly define a horizontal reference plane P, and an air-guiding room 43 may be formed between the horizontal reference plane P and the air-guiding protrusion 412 of the hub 41. Moreover, the top edge 421 of the vane 42 is spaced from the first cover portion 11 by a first distance D1, and the air-guiding plane 412 of the hub 41 is spaced from the first cover portion 11 by a second distance D2. The first distance D1 is designed in a larger value than the second distance D2 so that the air-guiding room 43 will have more space for air to pass therethrough.

The advection-type fan of the second embodiment of the invention is characterized in the ability to smoothly guide the air from the air inlet 131 to the air outlet 132 because the top edges 421 of the vane 42 are higher than the air-guiding plane 412 of the hub 41. In this way, the invention can reduce the amount of air blocked by the hub 41, thereby preventing turbulence and improving the overall cooling efficiency. In contrast to the first embodiment, the air-guiding plane 412 of the hub 41 is a simple plane instead of a protrusion, which further reduces the amount of air blocked by the hub 41 compared to the first embodiment. Thus, better cooling efficiency is provided.

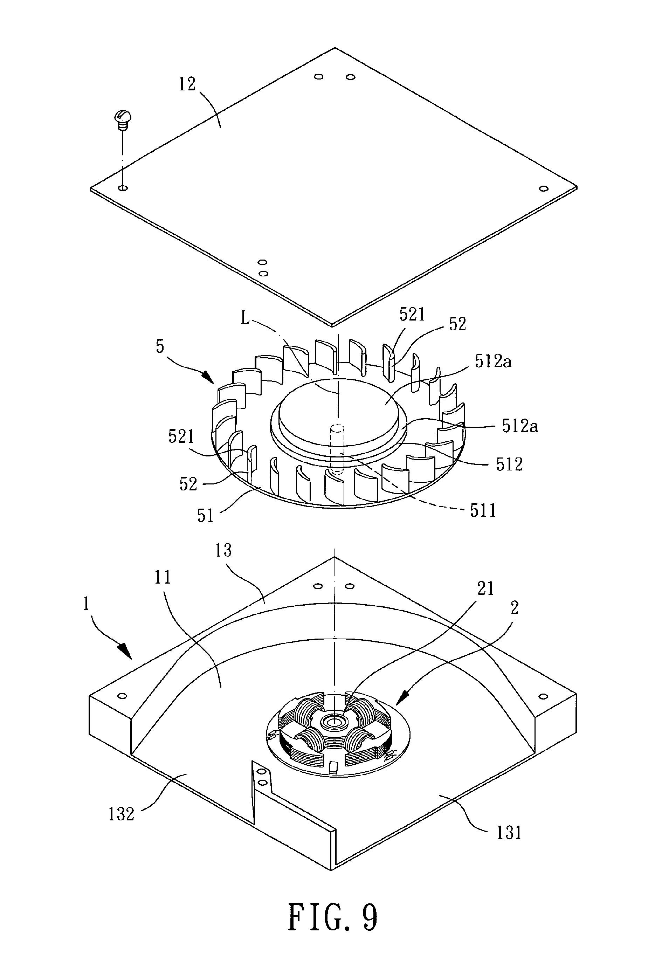

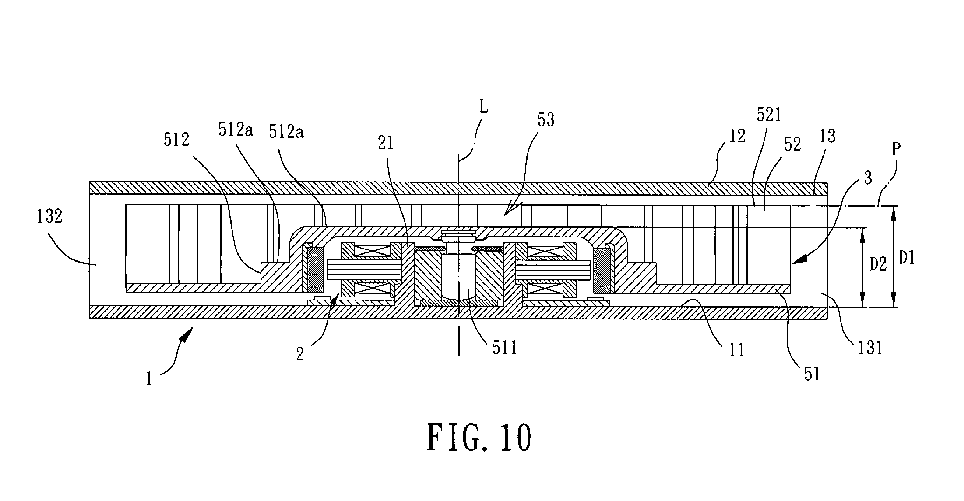

Referring to Figs. 9 and 10, an advection-type fan including a fan frame 1, a driving module 2 and an impeller 5 is disclosed according to a third embodiment of the invention. The fan frame 1 and the driving module 2 have been described previously. The impeller 5 comprises a hub 51 and a plurality of vanes 52, wherein the hub 51 may be rotatably coupled with the driving module 2. In this embodiment, the hub 51 has a shaft 511 rotatably coupled with the shaft seat 21 of the driving module 2, thus coupling the hub 51 with the driving module 2. The vanes 52 are coupled with the hub 51. Referring to Fig. 10, the hub 51 has a step portion 512 facing the second cover portion 12. The step portion 512 has a plurality of top faces 512a with different height in an axial direction L of the hub 51, and each vane 52 has a top edge 521 facing the second cover portion 12. The top edge 521 of the vane 52 is higher than one of the top faces 512a that is closest to the second cover portion 12 in the axial direction L of the hub 51 (compared to other portions of the hub 51).

Specifically, the top edges 521 of the vane 52 can jointly define a horizontal reference plane P, and an air-guiding room 53 may be formed between the horizontal reference plane P and the top face 512a closest to the second cover portion 12. Moreover, the top edge 521 of the vane 52 is spaced from the first cover portion 11 by a first distance D1, and the top face 512a of the hub 51 closest to the second cover portion 12 is spaced from the first cover portion 11 by a second distance D2. The first distance D1 is designed in a larger value than the second distance D2 so that the air-guiding room 53 will have more space for air to pass therethrough.

The advection-type fan of the third embodiment of the invention is characterized in the ability to smoothly guide the air from the air inlet 131 to the air outlet 132 because the top edges 521 of the vane 52 are higher than the top face 512a of the hub 51 closest to the second cover portion 12. In this way, the invention can reduce the amount of air blocked by the hub 51, thereby preventing turbulence and improving the overall cooling efficiency. In contrast to the first embodiment, the step portion 512 of the hub 51 can reduce the potential turbulence caused by lateral sides of the step portion 512 blocking the air passing through the step portion 512.

Based on the above structures of the advection-type fan, the first, second or third embodiment can be modified to include following structures for further improvement, as elaborated below.

Referring to Fig. 6, for example, the impeller 4 of the second embodiment may further include a reinforcing ring 44 coupled with the vanes 42 to improve the structural strength of the vanes 42.

Referring to Figs. 6 and 8, the impeller 4 of the second embodiment may further include a guiding cambered face 45 on a periphery of the hub 41 to provide better air-guiding effect.

Referring to Fig. 8, an extension direction E from the top edges 421 of the vanes 42 to one end of the vanes 42 connecting to the hub 41 is preferably parallel to the axial direction L of the hub 41. This allows the vanes 42 to more efficiently guide the air from the air inlet 131 to the air outlet 132 in the radial direction of the impeller 4.

Referring to Fig. 8, the extension direction E is preferably perpendicular to the air-guiding plane 412 of the hub 41. This also allows the vanes 42 to more efficiently guide the air from the air inlet 131 to the air outlet 132 in the radial direction of the impeller 4.

In the first to third embodiments previously described, the invention does efficiently reduce the amount of air blocked by the hub 31, 41, 51 based on the height difference between the vanes 32, 42, 52 of the impeller 3, 4, 5 and the hub 31, 41, 51. Therefore, the invention can prevent turbulence and improve overall cooling efficiency.

Although the invention has been described in detail with reference to its presently preferable embodiment, it will be understood by one of ordinary skill in the art that various modifications can be made without departing from the scope of the invention, as set forth in the appended claims.

## Claims

1. A cross-flow fan comprising the following features wherein the words top, bottom and lateral refer to a position of the fan in which its axial direction , which is the direction (L) of its rotation axis, is vertical:
a fan frame (1) having a first cover portion (11), a second cover portion (12) and a lateral wall portion (13) arranged between the first and second cover portions (11 and 12), wherein the lateral wall portion (13) has an air inlet (131) and an air outlet (132);
a driving module (2) as a stator of a motor received in the fan frame (1) and coupled with the first cover portion (11); and
an impeller (3, 4, 5) as a rotor of the motor having a hub (31) and a plurality of vanes (32), wherein the hub (31) is rotatably coupled with the driving module (2), and the vanes (32) are coupled with the hub (31);
wherein the hub (31) has an air-guiding protrusion (312) facing the second cover portion (12) and each of the vanes (32) has a top edge (321) facing the second cover portion (12), the air-guiding protrusion (312) has a top point (H) being an outmost point(s) of the hub (31) most adjacent to the second cover portion (12), and the top edge (321) of each of the vanes (32) is higher than the top point (H) of the hub (31) in a axial direction (L) of the hub (31),
wherein a bottom part of an outer periphery of the hub (31) has the same axial position in the axial direction (L) of the hub (31) as a bottom part of the rotor of the motor, wherein the hub (31) forms an elevated part from the top point (H) to the outer periphery thereof, and wherein the elevated part of the hub (31) receives the driving module (2),
wherein the cross-flow fan is **characterized in that** the top point (H) is a single top point, the air-guiding protrusion (312) of the hub (31) is a cambered face having a centre at which the single top point (H) is located, and the single top point (H) is located on the rotation axis of the cross-flow fan.

2. The cross-flow fan as claimed in claim 1, **characterized in that** an extension direction (E) from the top edges (321, 421, 521) of the vanes (32, 42, 52) to one end of the vanes (32, 42, 52) connecting to the hub (31, 41, 51) is parallel to the axial direction of the hub (31, 41, 51).

3. The cross-flow fan as claimed in claim 1, **characterized in that** the impeller (4) further includes a reinforcing ring (44) coupled with the vanes (42).

4. The cross-flow fan as claimed in claim 1, **characterized in that** the impeller (4) further includes a guiding cambered face (45) on a periphery of the hub (41).

5. The cross-flow fan as claimed in claim 1, **characterized in that** the top edges (321) of the vanes (32) jointly define a horizontal reference plane (P), and an air-guiding room (33) is formed between the horizontal reference plane (P) and the air-guiding protrusion (312) of the hub (31).

6. The cross-flow fan as claimed in claim 1, **characterized in that** the top edge (321) of each of the vanes (32) is spaced from the first cover portion (11) by a first distance (D1), the top point (H) of the hub (31) is spaced from the first cover portion (11) by a second distance (D2), and the first distance (D1) is larger than the second distance (D2).

## Patentansprüche

1. Querstromventilator, der die folgenden Merkmale umfasst, wobei sich die Begriffe oben, unten und seitlich auf eine Position des Ventilators beziehen, in der seine axiale Richtung, die die Richtung (L) seiner Drehachse ist, vertikal ist:
ein Ventilatorgehäuse (1), das einen ersten Abdeckabschnitt (11), einen zweiten Abdeckabschnitt (12) und einen seitlichen Wandabschnitt (13), der zwischen dem ersten und dem zweiten Abdeckabschnitt (11 und 12) angeordnet ist, umfasst, wobei der seitliche Wandabschnitt (13) einen Lufteinlass (131) und einen Luftauslass (132) aufweist;
ein Antriebsmodul (2) als einen Stator eines Motors, der in dem Ventilatorgehäuse (1) aufgenommen und mit dem ersten Abdeckabschnitt (11) gekoppelt ist; und
einen Läufer (3, 4, 5) als einen Rotor des Motors, der eine Nabe (31) und mehrere Schaufeln (32) aufweist, wobei die Nabe (31) mit dem Antriebsmodul (2) drehbar gekoppelt ist und wobei die Schaufeln (32) mit der Nabe (31) gekoppelt sind;
wobei die Nabe (31) einen luftführenden Vorsprung (312) aufweist, der dem zweiten Abdeckabschnitt (12) gegenüberliegt, und wobei jede der Schaufeln (32) eine oberste Kante (321) hat, die dem zweiten Abdeckabschnitt (12) gegenüberliegt, wobei der luftführende Vorsprung (312) einen obersten Punkt (H) hat, der einen oder mehrere äußerste Punkte der Nabe (31) bildet, die dem zweiten Abdeckabschnitt (12) am nächsten liegen, und wobei die oberste Kante (321) jeder der Schaufeln (32) höher als der oberste Punkt (H) der Nabe (31) in einer axialen Richtung (L) der Nabe (31) ist,
wobei
ein unterer Teil eines Außenumfangs der Nabe (31) die gleiche axiale Position in der axialen Richtung (L) der Nabe (31) wie ein unterer Teil des Rotors des Motors hat, wobei die Nabe (31) einen erhöhten Teil von dem obersten Punkt (H) zu dessen Außenumfang bildet, und wobei der erhöhte Teil der Nabe (31) das Antriebsmodul (2) aufnimmt,
wobei der Querstromventilator **dadurch gekennzeichnet ist, dass**
der oberste Punkt (H) ein einzelner oberster Punkt ist, wobei der luftführende Vorsprung (312) der Nabe (31) eine gewölbte Fläche ist, die ein Zentrum hat, bei dem sich der einzelne oberste Punkt (H) befindet, und wobei sich der einzelne oberste Punkt (H) bei der Drehachse des Querstromventilators befindet.

2. Querstromventilator nach Anspruch 1, **dadurch gekennzeichnet, dass** eine Ausdehnungsrichtung (E) von den obersten Kanten (321, 421, 521) der Schaufeln (32, 42, 52) zu einem Ende der Schaufeln (32, 42, 52), das mit der Nabe (31, 41, 51) verbunden ist, parallel zu der axialen Richtung der Nabe (31, 41, 51) ist.

3. Querstromventilator nach Anspruch 1, **dadurch gekennzeichnet, dass** der Läufer (4) ferner einen mit den Schaufeln (42) gekoppelten Verstärkungsring (44) umfasst.

4. Querstromventilator nach Anspruch 1, **dadurch gekennzeichnet, dass** der Läufer (4) ferner eine führende gewölbte Fläche (45) an einem Umfang der Nabe (41) umfasst.

5. Querstromventilator nach Anspruch 1, **dadurch gekennzeichnet, dass** die obersten Kanten (321) der Schaufeln (32) gemeinsam eine horizontale Bezugsebene (P) definieren und dass ein luftführender Raum (33) zwischen der horizontalen Bezugsebene (P) und dem luftführenden Vorsprung (312) der Nabe (31) gebildet ist.

6. Querstromventilator nach Anspruch 1, **dadurch gekennzeichnet, dass** die oberste Kante (321) jeder der Schaufeln (32) von dem ersten Abdeckabschnitt (11) mit einem ersten Abstand (D1) beabstandet ist, der oberste Punkt (H) der Nabe (31) von dem ersten Abdeckabschnitt (11) mit einem zweiten Abstand (D2) beabstandet ist und dass der erste Abstand (D1) größer als der zweite Abstand (D2) ist.

## Revendications

1. Ventilateur tangentiel comprenant les caractéristiques suivantes dans lesquelles les termes supérieur, inférieur et latéral font référence à une position du ventilateur dans laquelle sa direction axiale, qui est la direction (L) de son axe de rotation, est verticale :
un bâti de ventilateur (1) ayant une première partie de couvercle (11), une seconde partie de couvercle (12) et une partie de paroi latérale (13) agencée entre les première et seconde parties de couvercle (11 et 12), dans lequel la partie de paroi latérale (13) a une entrée d'air (131) et une sortie d'air (132) ;
un module d'entraînement (2) en tant que stator d'un moteur reçu dans le bâti de ventilateur (1) et couplé avec la première partie de couvercle (11) ; et
une roue (3, 4, 5) en tant que rotor du moteur ayant un moyeu (31), et une pluralité de pales (32), dans lequel le moyeu (31) est couplé en rotation avec le module d'entraînement (2), et les pales (32) sont couplées avec le moyeu (31) ;
dans lequel le moyeu (31) a une saillie de guidage d'air (312) faisant face à la seconde partie de couvercle (12) et chacune des pales (32) a un bord supérieur (321) faisant face à la seconde partie de couvercle (12), la saillie de guidage d'air (312) a un point haut (H) qui est le(s) point(s) le plus à l'extérieur du moyeu (31) le plus adjacent à la seconde partie de couvercle (12), et le bord supérieur (321) de chacune des pales (32) est plus haut que le point haut (H) du moyeu (31) dans une direction axiale (L) du moyeu (31),
dans lequel une partie inférieure d'une périphérie externe du moyeu (31) a la même position axiale dans la direction axiale (L) du moyeu (31) en tant que partie inférieure du rotor du moteur, dans lequel le moyeu (31) forme une partie élevée à partir du point haut (H) jusqu'à sa périphérie externe, et dans lequel la partie élevée du moyeu (31) reçoit le module d'entraînement (2),
dans lequel le ventilateur tangentiel est **caractérisé en ce que** le point haut (H) est un point haut unique, la saillie de guidage d'air (312) du moyeu (31) est une face cambrée ayant un centre auquel le point haut unique (H) est positionné, et le point haut unique (H) est positionné sur l'axe de rotation du ventilateur tangentiel.

2. Ventilateur tangentiel selon la revendication 1, **caractérisé en ce qu'**une direction d'extension (E) à partir des bords supérieurs (321, 421, 521) des pales (32, 42, 52) jusqu'à une extrémité des pales (32, 42, 52) se raccordant au moyeu (31, 41, 51) est parallèle à la direction axiale du moyeu (31, 41, 51).

3. Ventilateur tangentiel selon la revendication 1, **caractérisé en ce que** la roue (4) comprend en outre une bague de renforcement (44) couplée avec les pales (42).

4. Ventilateur tangentiel selon la revendication 1, **caractérisé en ce que** la roue (4) comprend en outre une face cambrée de guidage (45) sur une périphérie du moyeu (41).

5. Ventilateur tangentiel selon la revendication 1, **caractérisé en ce que** les bords supérieurs (321) des pales (32) définissent conjointement un plan de référence horizontal (P) et un espace de guidage d'air (33) est formé entre le plan de référence horizontal (P) et une saillie de guidage d'air (312) du moyeu (31).

6. Ventilateur tangentiel selon la revendication 1, **caractérisé en ce que** le bord supérieur (321) de chacune des pales (32) est éloigné de la première partie de couvercle (11) par une première distance (D1), le point haut (H) du moyeu (31) est éloigné de la première partie de couvercle (11) par une seconde distance (D2), et la première distance (D1) est plus grande que la seconde distance (D2).
